# EUROPEAN PATENT APPLICATION

(11) **EP 4 475 438 A1**
(43) Date of publication of application: **11.12.2024**
(21) Application number: 24180527.4
(22) Date of filing: 06.06.2024
(51) Int. Cl.: H03K 17/082, H03K 17/16

(54) **SWITCHING CIRCUIT, DRIVE MODULE, CONTROL METHOD, AND POWER SUPPLY DEVICE**

(30) Priority: 07.06.2023 CN 202310672159
(71) Applicant: Huawei Digital Power Technologies Co., Ltd., Shenzhen, Guangdong 518043 (CN)
(72) Inventor: JIANG, Hua, Shenzhen, 518043 (CN); HUANG, Yiyi, Shenzhen, 518043 (CN); LUO, Haisong, Shenzhen, 518043 (CN)
(74) Representative: Gill Jennings & Every LLP

(57) **Abstract**

This application provides a switching circuit, a drive module, a control method, and a power supply device. The switching circuit is configured to conduct or cut off power supplied by a power supply apparatus to a load. The switching circuit includes: a sampling unit, a switch component, and a control circuit. A first end of the sampling unit is configured to connect to an output end of the power supply apparatus. One end of the switch component is configured to connect to a second end of the sampling unit. The other end of the switch component is configured to connect to the load. The control circuit is connected to the second end of the sampling unit and a control end of the switch component. The control circuit is configured to: in response to that a sampling voltage at the second end of the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration. The second duration is greater than the first duration.

## Description

### TECHNICAL FIELD

This application relates to the field of power electronics technologies, and in particular, to a switching circuit, a drive module, a control method, and a power supply device.

### BACKGROUND

Direct current output of a power supply apparatus is generally connected in series to a switching circuit, to implement power-on and power-off control of each branch load connected to the direct current output. The switching circuit usually uses a semiconductor switch to conduct and cut off power supply. When the semiconductor switch is used to implement switching between a conducted state and a cut off state, a proper control method needs to be used to resolve an overstress problem of an output power supply port in a short circuit working condition or the like. In some existing switching circuits, a single control manner is used. This may result in a case in which the circuit cannot implement self-recovery after a short circuit or a requirement of a load for transient power outage time is not met. Therefore, how to design a switching circuit in which the circuit implements self-recovery from a short circuit and a requirement of a load for transient power outage time is met becomes a technical problem to be urgently resolved currently.

### SUMMARY

In view of the foregoing problem, this application provides a switching circuit, a drive module, a control method, and a power supply device, to implement self-recovery of the circuit from a short circuit, and meet a requirement of a load for transient power outage time.

According to a first aspect, this application provides a switching circuit. The switching circuit is configured to conduct or cut off power supplied by a power supply apparatus to a load. The switching circuit includes: a sampling unit, a switch component, and a control circuit. A first end of the sampling unit is configured to connect to an output end of the power supply apparatus. One end of the switch component is configured to connect to a second end of the sampling unit. The other end of the switch component is configured to connect to the load. The control circuit is connected to the second end of the sampling unit and a control end of the switch component. The control circuit is configured to: in response to that a sampling voltage at the second end of the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration. The second duration is greater than the first duration.

It may be understood that the control circuit controls, based on a first-level control policy in response to that the sampling voltage reaches the first reference voltage, the switch component to cut off power supply for a short time, that is, the switch component is turned on after the switch component is turned off for the first duration. The control circuit controls, based on a second-level control policy in response to that the quantity of times the sampling voltage reaches the first reference voltage in the preset duration reaches the preset quantity of times, the switch component to cut off power supply for a long time, that is, the switch component is turned on after the switch component is turned off for the second duration. The switching circuit is disconnected for a short time during a single overcurrent to meet a requirement of the load for power outage time, and is disconnected for a long time to address impact of a long-time overcurrent on the load. The power supplied by the power supply apparatus to the load is conducted after the switching circuit is disconnected for the first duration or the second duration, so that a requirement for self-recovery of the circuit can be met.

With reference to the first aspect of this application, in a possible implementation, the control circuit includes: a comparison unit, configured to: receive the first reference voltage and the sampling voltage; and in response to that the sampling voltage reaches the first reference voltage, output an overcurrent signal; a control module, configured to: in response to the overcurrent signal, output a turn-off signal for the first duration; in response to that a quantity of times of the overcurrent signal in the preset duration reaches the preset quantity of times, output the turn-off signal for the second duration; and in response to that the first duration or the second duration ends, output a turn-on signal, where the second duration is greater than the first duration; and a drive module, configured to: in response to the turn-off signal, turn off the switch component; and in response to the turn-on signal, turn on the switch component.

With reference to the first aspect of this application, in a possible implementation, the drive module includes a first turn-off loop and a second turn-off loop. In response to the turn-off signal, a gate-source voltage of the switch component decreases. In response to that the gate-source voltage of the switch component is greater than a preset value, a current flowing through the first turn-off loop is greater than a current flowing through the second turn-off loop. In response to that the gate-source voltage of the switch component decreases to be less than or equal to a preset value, a current flowing through the first turn-off loop is less than or equal to a current flowing through the second turn-off loop. The preset value is greater than a turn-off threshold voltage of the switch component.

With reference to the first aspect of this application, in a possible implementation, the drive module includes a turn-off unit. The first turn-off loop includes a first resistor and a Zener diode. The second turn-off loop includes a second resistor. A resistance value of the first resistor is less than a resistance value of the second resistor. A first end of the first turn-off loop and a first end of the second turn-off loop are separately connected to the control end of the switch component. A second end of the first turn-off loop and a second end of the second turn-off loop are separately connected to a first end of the turn-off unit. A second end of the turn-off unit is connected to a source of the switch component. In response to that a third end of the turn-off unit receives the turn-off signal, the first end of the turn-off unit is connected, with a low impedance, to the second end of the turn-off unit, so that the gate-source voltage of the switch component decreases. In response to that the gate-source voltage of the switch component is less than a reverse breakdown voltage of the Zener diode, no current passes through the first turn-off loop.

It may be understood that, the loop in which the first resistor is located can form a first discharging loop to quickly turn off the switch component, and the loop in which the second resistor is located can form a second discharging loop to slowly turn off the switch component. Two levels of turn-off control are set, and this can resolve a problem that voltage overstress and current overstress cannot be resolved when the switch component is controlled to be turned off in a scenario in which a current of a line changes sharply, for example, in a short circuit or lightning strike working condition. In this way, requirements for voltage and current specifications of the switch component are greatly reduced.

With reference to the first aspect of this application, in a possible implementation, the control module includes a discrete element and/or an integrated element.

With reference to the first aspect of this application, in a possible implementation, the comparison unit and the control module are integrated into a same chip.

With reference to the first aspect of this application, in a possible implementation, one end of the sampling unit is connected to a negative electrode of a negative output end of the power supply apparatus, and the other end of the switch component is connected to a negative input end of the load. Alternatively, one end of the sampling unit is connected to a positive output end of the power supply apparatus, and the other end of the switch component is connected to a positive input end of the load.

With reference to the first aspect of this application, in a possible implementation, the power supply apparatus is configured to convert an alternating current input voltage into a direct current output voltage, or the power supply apparatus is configured to convert a direct current input voltage into a direct current output voltage.

According to a second aspect, this application provides a drive module. The drive module is configured to drive a switch component. The drive module includes a first turn-off loop and a second turn-off loop. In response to a turn-off signal, a gate-source voltage of the switch component decreases. In response to that the gate-source voltage of the switch component is greater than a preset value, a current flowing through the first turn-off loop is greater than a current flowing through the second turn-off loop. In response to that the gate-source voltage of the switch component decreases to be less than or equal to a preset value, a current flowing through the first turn-off loop is less than or equal to a current flowing through the second turn-off loop. The preset value is greater than a turn-off threshold voltage of the switch component.

With reference to the second aspect of this application, in a possible implementation, the drive module includes a turn-off unit. The first turn-off loop includes a first resistor and a Zener diode. The second turn-off loop includes a second resistor. A resistance value of the first resistor is less than a resistance value of the second resistor. A first end of the first turn-off loop and a first end of the second turn-off loop are separately connected to a control end of the switch component. A second end of the first turn-off loop and a second end of the second turn-off loop are separately connected to a first end of the turn-off unit. A second end of the turn-off unit is connected to a source of the switch component. In response to that a third end of the turn-off unit receives the turn-off signal, the first end of the turn-off unit is connected, with a low impedance, to the second end of the turn-off unit, so that the gate-source voltage of the switch component decreases. In response to that the gate-source voltage of the switch component is less than a reverse breakdown voltage of the Zener diode, no current passes through the first turn-off loop.

According to a third aspect, this application provides a switching circuit. The switching circuit is configured to conduct or cut off power supplied by a power supply apparatus to a load. The switching circuit includes: a sampling unit, where a first end of the sampling unit is configured to connect to an output end of the power supply apparatus; a switch component, where one end of the switch component is configured to connect to a second end of the sampling unit, and the other end of the switch component is configured to connect to the load; and a control circuit, where the control circuit includes a control module and a drive module. The control module is configured to: in response to that a sampling voltage at the second end of the sampling unit meets a preset condition, output a turn-off signal. The drive module is configured to: in response to the turn-off signal, turn off the switch component. The drive module includes a first turn-off loop and a second turn-off loop. In response to the turn-off signal, a gate-source voltage of the switch component decreases. In response to that the gate-source voltage of the switch component is greater than a preset value, a current flowing through the first turn-off loop is greater than a current flowing through the second turn-off loop. In response to that the gate-source voltage of the switch component decreases to be less than or equal to a preset value, a current flowing through the first turn-off loop is less than or equal to a current flowing through the second turn-off loop. The preset value is greater than a turn-off threshold voltage of the switch component.

With reference to the third aspect of this application, in a possible implementation, the drive module includes a turn-off unit. The first turn-off loop includes a first resistor and a Zener diode. The second turn-off loop includes a second resistor. A resistance value of the first resistor is less than a resistance value of the second resistor. A first end of the first turn-off loop and a first end of the second turn-off loop are separately connected to a control end of the switch component. A second end of the first turn-off loop and a second end of the second turn-off loop are separately connected to a first end of the turn-off unit. A second end of the turn-off unit is connected to a source of the switch component. In response to that a third end of the turn-off unit receives the turn-off signal, the first end of the turn-off unit is connected, with a low impedance, to the second end of the turn-off unit, so that the gate-source voltage of the switch component decreases. In response to that the gate-source voltage of the switch component is less than a reverse breakdown voltage of the Zener diode, no current passes through the first turn-off loop.

With reference to the third aspect of this application, in a possible implementation, the preset condition is that the sampling voltage reaches a first reference voltage, or a quantity of times the sampling voltage reaches the first reference voltage in preset duration reaches a preset quantity of times. The control circuit is configured to: in response to that the sampling voltage reaches the first reference voltage, control the switch component to be turned on after the switch component is turned off for first duration; and in response to that the quantity of times the sampling voltage reaches the first reference voltage in the preset duration reaches the preset quantity of times, control the switch component to be turned on after the switch component is turned off for second duration. The second duration is greater than the first duration.

With reference to the third aspect of this application, in a possible implementation, the control circuit includes: a comparison unit, configured to: receive the first reference voltage and the sampling voltage; and in response to that the sampling voltage reaches the first reference voltage, output an overcurrent signal. The control module is configured to: in response to the overcurrent signal, output the turn-off signal for the first duration; in response to that a quantity of times of the overcurrent signal in the preset duration reaches the preset quantity of times, output the turn-off signal for the second duration; and in response to that the first duration or the second duration ends, output a turn-on signal. The second duration is greater than the first duration. The drive module is configured to: in response to the turn-off signal, turn off the switch component; and in response to the turn-on signal, turn on the switch component.

According to a fourth aspect, this application provides a switching circuit control method. The switching circuit includes a sampling unit and a switch component. A first end of the sampling unit is configured to connect to an output end of a power supply apparatus. One end of the switch component is configured to connect to a second end of the sampling unit. The other end of the switch component is configured to connect to a load. The method includes: obtaining a sampling voltage at the second end of the sampling unit; in response to that the sampling voltage reaches a first reference voltage, controlling the switch component to be turned on after the switch component is turned off for first duration; and in response to that a quantity of times the sampling voltage reaches the first reference voltage in preset duration reaches a preset quantity of times, controlling the switch component to be turned on after the switch component is turned off for second duration. The second duration is greater than the first duration.

According to a fifth aspect, this application provides a power supply device. The power supply device includes a power supply apparatus and a switching circuit. The power supply apparatus is configured to provide a direct current output voltage for a load. The switching circuit is configured to conduct or cut off power supplied by the power supply apparatus to the load. The switching circuit includes a sampling unit, a switch component, and a control circuit. A first end of the sampling unit is configured to connect to an output end of the power supply apparatus. One end of the switch component is configured to connect to a second end of the sampling unit. The other end of the switch component is configured to connect to the load. The control circuit is connected to the second end of the sampling unit and a control end of the switch component. The control circuit is configured to: in response to that a sampling voltage at the second end of the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration. The second duration is greater than the first duration.

According to a sixth aspect, this application provides a power supply device. The power supply device includes a power supply apparatus and a switching circuit. The power supply apparatus is configured to provide a direct current output voltage for a load. The switching circuit is configured to conduct or cut off power supplied by the power supply apparatus to the load. The switching circuit includes a sampling unit, a switch component, and a control circuit. The control circuit includes a control module and a drive module. The control module is configured to: in response to that a sampling voltage at a second end of the sampling unit meets a preset condition, output a turn-off signal. The drive module is configured to: in response to the turn-off signal, turn off the switch component. The drive module includes a first turn-off loop and a second turn-off loop. In response to the turn-off signal, a gate-source voltage of the switch component decreases. In response to that the gate-source voltage of the switch component is greater than a preset value, a current flowing through the first turn-off loop is greater than a current flowing through the second turn-off loop. In response to that the gate-source voltage of the switch component decreases to be less than or equal to a preset value, a current flowing through the first turn-off loop is less than or equal to a current flowing through the second turn-off loop. The preset value is greater than a turn-off threshold voltage of the switch component.

In addition, for technical effects brought by any possible implementation of the second aspect to the sixth aspect, refer to technical effects brought by different implementations of the first aspect. Details are not described herein again.

### BRIEF DESCRIPTION OF DRAWINGS

FIG. 1 is a schematic of an application scenario of a switching circuit;
FIG. 2 is a schematic of connecting a switching circuit to a power supply apparatus and a load according to an embodiment of this application;
FIG. 3 is a schematic of a control circuit in FIG. 2 according to an embodiment of this application;
FIG. 4 is another schematic of a control circuit in FIG. 2 according to an embodiment of this application;
FIG. 5 is a schematic flowchart of a switching circuit control method according to an embodiment of this application;
FIG. 6 is an example of a schematic of a connection between a drive module and a switch component;
FIG. 7 is a waveform diagram of a voltage and a current in a turn-off process of the switch component in FIG. 6;
FIG. 8 is a schematic of connection between a drive module and a switch component according to an embodiment of this application;
FIG. 9 is a schematic of a drive module in FIG. 2 according to an embodiment of this application;
FIG. 10 is another schematic of a drive module in FIG. 2 according to an embodiment of this application; and
FIG. 11 is a waveform diagram of a voltage in a turn-off process of a switch component.

### DESCRIPTION OF EMBODIMENTS

The following clearly describes technical solutions in embodiments of this application with reference to accompanying drawings in embodiments of this application.

It may be understood that a connection relationship described in this application is a direct or indirect connection. For example, that A is connected to B may be that A is directly connected to B, or may be that A is indirectly connected to B by using one or more other electrical components. For example, A may be directly connected to C, and C may be directly connected to B, so that A and B are connected by using C. It may be further understood that "A is connected to B" described in this application may be that A is directly connected to B, or may be that A is indirectly connected to B by using one or more other electrical components.

In descriptions of this application, unless otherwise specified, "/" means "or". For example, A/B may indicate A or B. A term "and/or" in this specification describes only an association relationship between associated objects and indicates that there may be three relationships. For example, A and/or B may represent the following three cases: Only A exists, both A and B exist, and only B exists.

In descriptions of this application, the words such as "first", "second", and the like are merely used to distinguish between different objects, and do not limit quantities and execution sequences. In addition, the words such as "first", "second", and the like do not indicate a definite difference. In addition, terms "include", "have", or any other variant thereof are intended to cover a non-exclusive inclusion.

The technical solutions of this application are further described below in detail with reference to the accompanying drawings.

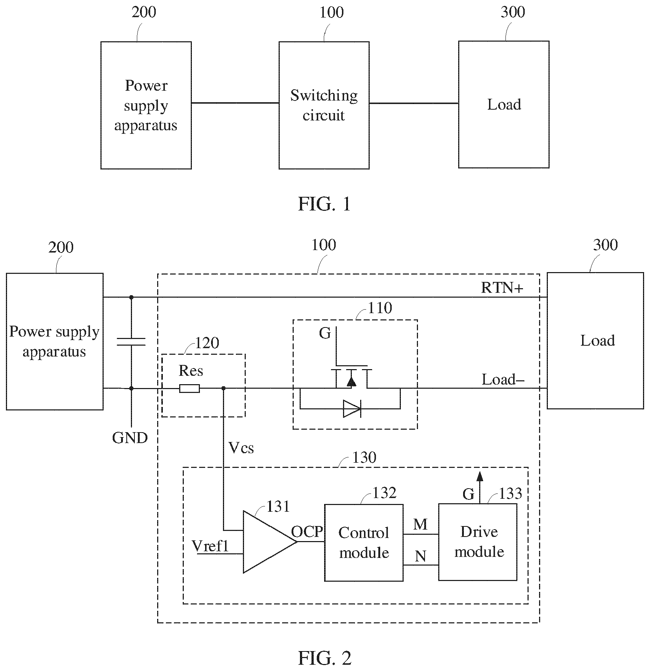

FIG. 1 is a schematic of an application scenario of a switching circuit according to this application.

A power supply apparatus 200 is configured to supply power to one or more loads 300. A switching circuit 100 is disposed between the one or more loads 300 and the power supply apparatus 200. One end of the switching circuit 100 is connected to the power supply apparatus 200, and the other end of the switching circuit 100 is connected to the load 300. The switching circuit 100 is configured to conduct or cut off the power supplied by the power supply apparatus 200 to the load 300.

A quantity of switching circuits 100 may be less than or equal to a quantity of loads 300. In other words, the switching circuit 100 is disposed between each load 300 and the power supply apparatus 200, or the switching circuit 100 is disposed between some loads 300 and the power supply apparatus 200, and remaining loads 300 are directly connected to the power supply apparatus 200.

It may be understood that the switching circuit 100 is disposed between an output end and the load 300, so that the power supply apparatus 200 can flexibly implement power-on and power-off control of each load 300, to meet requirements of energy saving and load management.

In actual application, the power supply apparatus 100 may be used in different scenarios. For example, the power supply apparatus 100 may be a voltage converter or a battery used for a communication base station, and the power supply apparatus 100 is configured to output a direct current voltage.

In a possible implementation, the power supply apparatus 200 is a voltage converter. The power supply apparatus 200 may be an alternating current to direct current (alternating current to direct current, AC-DC) voltage converter configured to convert an alternating current input voltage into a direct current output voltage. The power supply apparatus 200 may alternatively be a direct current to direct current (direct current to direct current, DC-DC) voltage converter configured to convert a direct current input voltage into a direct current output voltage. In another possible implementation, the power supply apparatus 200 is an energy storage apparatus, for example, a battery.

The switching circuit 100 usually uses a semiconductor switch component to conduct and cut off a direct current voltage in the circuit. It should be understood that the semiconductor switch component may be a metal-oxide-semiconductor field-effect transistor (metal-oxide-semiconductor field-effect transistor, MOSFET) or an insulated gate bipolar transistor (insulated gate bipolar transistor, IGBT) made of materials such as a silicon (silicon, Si) semiconductor material, a third-generation wide band gap semiconductor material, namely, silicon carbide (silicon carbide, SiC), or gallium nitride (gallium nitride, GaN). This is not limited in this application.

In order to implement overcurrent protection, signal sampling is usually performed for the switching circuit 100. When an overcurrent signal is sampled, the semiconductor switch component is controlled to be turned off and locked, or is turned on after the switch component is turned off for fixed duration. However, if the semiconductor switch component is directly locked, the circuit cannot implement self-recovery. If the semiconductor switch component is turned on after the switch component is turned off for fixed duration, the fixed duration should be long due to impact of a temperature rise factor of the semiconductor switch component. However, if turn-off time is excessively long, a requirement of the load 300 for transient power outage time is not met. For example, the transient power outage time of the load 300 is required to be less than 1 ms or even less.

Embodiments of this application provide a switching circuit, a switching circuit control method, and a power supply device, to resolve, by using a two-level control policy, a problem that the circuit cannot implement self-recovery from a short circuit or the requirement of the load for the transient power outage time is not met, which may result from adoption of single turn-off control by the semiconductor switch component.

An embodiment of this application provides a switching circuit. The switching circuit is configured to conduct or cut off power supplied by a power supply apparatus to a load. The switching circuit includes a sampling unit, a switch component, and a control circuit. A first end of the sampling unit is configured to connect to an output end of the power supply apparatus. One end of the switch component is configured to connect to a second end of the sampling unit, and the other end of the switch component is configured to connect to the load. The control circuit is connected to the second end of the sampling unit, and is configured to receive a sampling voltage at the second end. The control circuit is connected to a control end of the switch component. The control circuit is further configured to: in response to that the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration. The second duration is greater than the first duration.

An embodiment of this application provides a power supply device. The power supply device includes a power supply apparatus and a switching circuit. The switching circuit is configured to conduct or cut off power supplied by the power supply apparatus to a load. The switching circuit includes a sampling unit, a switch component, and a control circuit. A first end of the sampling unit is configured to connect to an output end of the power supply apparatus. One end of the switch component is configured to connect to a second end of the sampling unit, and the other end of the switch component is configured to connect to the load. The control circuit is connected to the second end of the sampling unit, and is configured to receive a sampling voltage at the second end. The control circuit is connected to a control end of the switch component. The control circuit is further configured to: in response to that the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration. The second duration is greater than the first duration.

In the switching circuit provided in embodiments of this application and the power supply device in which the switching circuit is used, the control circuit controls, based on a first-level control policy in response to that the sampling voltage reaches the first reference voltage, the switch component to be turned off for a short time, that is, the switch component is turned on after the switch component is turned off for the first duration. The control circuit controls, based on a second-level control policy in response to that the quantity of times the sampling voltage reaches the first reference voltage in the preset duration reaches the preset quantity of times, the switch component to be turned off for a long time, that is, the switch component is turned on after the switch component is turned off for the second duration. In the switching circuit, power supply is cut off for a short time during a single overcurrent to meet a requirement of the load for power outage time, and power supply is cut off for a long time to address impact of a long-time overcurrent on the load. The power supplied by the power supply apparatus to the load is conducted after the switching circuit is disconnected for the first duration or the second duration, so that a requirement for self-recovery of the circuit can be met.

FIG. 2 is a schematic of connecting a switching circuit to a power supply apparatus and a load according to an embodiment of this application. A switching circuit 100 includes a switch component 110, a sampling unit 120, and a control circuit 130.

The switch component 110 is configured to conduct or cut off power supplied by a power supply apparatus 200 to a load 300. A first end of the switch component 110 is connected to an output end of the power supply apparatus 200 by using the sampling unit 120, to receive the power supplied by the power supply apparatus 200. A second end of the switch component 110 is connected to an input end of the load 300 to supply power to the load 300.

The sampling unit 120 is configured to detect a sampling voltage Vcs at the output end of the power supply apparatus 200. A first end of the sampling unit 120 is configured to connect to the output end of the power supply apparatus 200, for example, connected to a negative output end of the power supply apparatus 200. A second end of the sampling unit 120 is connected to the first end of the switch component 110.

In embodiments of this application, a specific element used by the sampling unit 120 is not limited. For example, the sampling unit 120 may use a precision resistor Res shown in FIG. 2, or a component such as a current transformer or a Hall effect sensor.

In actual application, the switch component 110 may be disposed on a positive or negative line of the power supply apparatus 200. Correspondingly, the first end of the sampling unit 120 is configured to connect to a positive output end or a negative output end of the power supply apparatus 200, and the second end of the switch component 110 is connected to a positive input end or a negative input end of the load 300. This is not limited in embodiments of this application. That the sampling unit 120 shown in FIG. 2 is connected to the negative output end Load- of the power supply apparatus 200, and the second end of the switch component 110 is connected to the negative input end of the load 300 is merely a possible case. In this case, a positive power supply port RTN+ of the power supply apparatus 200 is connected to the positive input end of the load 300. A negative power supply port Load- of the power supply apparatus 200 is connected to the load 300 by using the sampling unit 120 and the switch component 110.

The control circuit 130 is connected to the second end of the sampling unit 120 and the first end of the switch component 110, and is configured to receive the sampling voltage Vcs at the second end of the sampling unit 120. The control circuit 130 is configured to: in response to that the sampling voltage Vcs reaches a first reference voltage, control the switch component 110 to be turned on after the switch component is turned off for first duration; and in response to that a quantity of times the sampling voltage Vcs reaches the first reference voltage in preset duration reaches a preset quantity of times, control the switch component 110 to be turned on after the switch component is turned off for second duration. The second duration is greater than the first duration.

It may be understood that the control circuit 130 controls, based on a first-level control policy in response to that the sampling voltage Vcs reaches the first reference voltage, the switch component 110 to be turned off for a short time, that is, the switch component is turned on after the switch component is turned off for the first duration. The control circuit 130 controls, based on a second-level control policy in response to that the quantity of times the sampling voltage Vcs reaches the first reference voltage in the preset duration reaches the preset quantity of times, the switch component 110 to be turned off for a long time, that is, the switch component is turned on after the switch component is turned off for the second duration. The switching circuit 100 is disconnected for a short time during a single overcurrent to meet a requirement of the load 300 for power outage time, and is disconnected for a long time to address impact of a long-time overcurrent on the load 300. The power supplied by the power supply apparatus 200 to the load 300 is conducted after the switching circuit 100 is disconnected for the first duration or the second duration, so that a requirement for self-recovery of the circuit can be met.

In some embodiments, the control circuit 130 shown in FIG. 2 includes a comparison unit, a control module, and a drive module. The comparison unit is configured to: receive the first reference voltage and the sampling voltage; and in response to that the sampling voltage reaches the first reference voltage, output an overcurrent signal. The control module is configured to: in response to the overcurrent signal, output a turn-off signal M for the first duration; in response to that a quantity of times of the overcurrent signal in the preset duration reaches the preset quantity of times, output the turn-off signal M for the second duration; and in response to that the first duration or the second duration ends, output a turn-on signal. The second duration is greater than the first duration. The drive module is configured to: in response to the turn-off signal M, turn off the switch component; and in response to the turn-on signal, turn on the switch component.

Specifically, as shown in FIG. 2, the control circuit 130 includes a comparison unit 131, a control module 132, and a drive module 133.

A first input end of the comparison unit 131 is configured to connect to the second end of the sampling unit 120, to receive the sampling voltage Vcs at the second end of the sampling unit 120. A second input end of the comparison unit 131 is configured to receive a first reference voltage Vref1. The comparison unit 131 is configured to: in response to that the sampling voltage Vcs reaches the first reference voltage Vref1, output an overcurrent signal OCP.

A specific structure of the comparison unit 131 is not limited in embodiments of this application. In a possible implementation, the comparison unit 131 may be a comparator or an operational amplifier. In another possible implementation, the comparison unit 131 and the control module 132 are integrated into a same processing chip.

An input end of the control module 132 is configured to connect to an output end of the comparison unit 131 to receive the overcurrent signal OCP. An output end of the control module 132 is connected to the drive module 133. The control module 132 is configured to: in response to the overcurrent signal OCP, output the turn-off signal M for the first duration; and in response to that a quantity of times of the overcurrent signal OCP in the preset duration reaches the preset quantity of times, output the turn-off signal M for the second duration. The second duration is greater than the first duration.

In a possible implementation, the control module 132 is further configured to: in response to that the first duration or the second duration ends, output a turn-on signal N. In other words, the control module 132 can output the turn-on signal N when the turn-off signal M is not output.

An input end of the drive module 133 is connected to the output end of the control module 132. An output end of the drive module 133 is connected to the switch component 110, for example, connected to a gate of the switch component 110. The drive module 133 is configured to: in response to the turn-off signal M, turn off the switch component 110; and in response to the turn-on signal N, turn on the switch component 110. For example, the drive module 133 can set a drive signal G to a high level in response to the turn-on signal N, and set the drive signal G to a low level in response to the turn-off signal M. The high-level drive signal G is used to turn on the switch component 110, and the low-level drive signal G is used to turn off the switch component 110.

It may be understood that the control module 132 outputs the turn-off signal M for the first duration in response to the overcurrent signal OCP, so that the drive module 133 turns off the switch component 110. In this way, the first-level control policy of the control circuit 130 can be implemented. The control module 132 outputs the turn-off signal M for the second duration in response to that the quantity of times of the overcurrent signal OCP in the preset duration reaches the preset quantity of times, so that the drive module 133 turns off the switch component 110. In this way, the second-level control policy of the control circuit 130 can be implemented.

It may be understood that, the first duration is adjusted, for example, the first duration is set to be less than 1 ms, so that a requirement for transient power outage time in surge and lightning strike working conditions can be met. The second duration is adjusted, for example, the second duration is extended, so that thermal stress of the switch component 110 in overload and short circuit working conditions can be reduced.

A specific structure of the control module 132 is not limited in embodiments of this application. For example, functions of the control module 131 may be implemented by an integrated component, or may be implemented by a discrete component, or may be implemented by both an integrated component and a discrete component.

In some embodiments, all the functions of the control module 132 are implemented by using an integrated logic component.

In these embodiments, the control module 132 is a processor, and may include an integrated circuit, for example, may include a single packaged integrated circuit, or may include a plurality of integrated circuits with a same function or different functions, including one or more central processing units (Central Processing units, CPUs), micro controller units (Micro Controller Units, MCUs), digital signal processing (Digital Signal Processing, DSP) chips, complex programmable logic device (Complex Programmable Logic Device, CPLD) chips, field programmable gate array (Field Programmable Gate Array, FPGA) chips, and single-chip microcomputers, and a combination of various control chips.

In some embodiments, a part of functions of the control module 132, that is, the first-level control policy, are implemented by using the integrated logic component, and the other part of functions of the control module 132, that is, the second-level control policy, are implemented by using the discrete component.

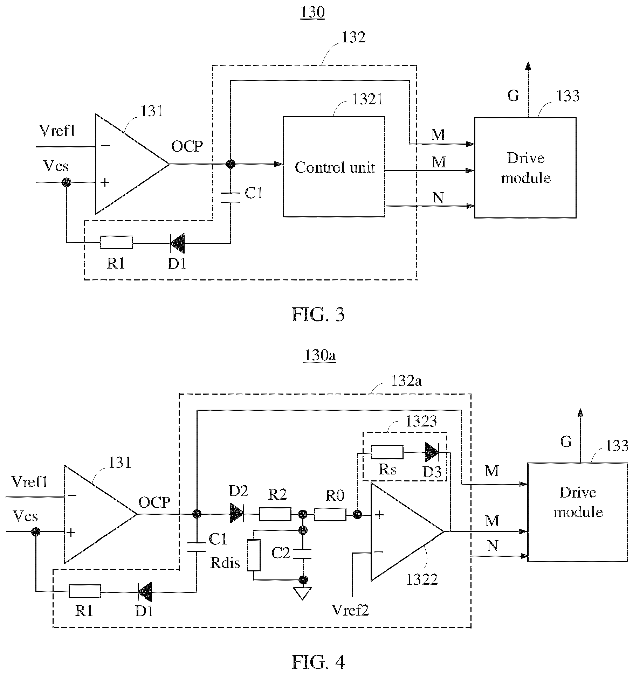

FIG. 3 is a schematic of the control circuit 130 in FIG. 2 according to an embodiment of this application.

As shown in FIG. 3, the control circuit 130 includes the comparison unit 131, the control module 132, and the drive module 133. The control module 132 includes a control unit 1321, a resistor R1, a diode D1, and a capacitor C1.

A first end of the resistor R1 is connected to the first input end of the comparison unit 131 to receive the sampling voltage Vcs. A second end of the resistor R1 is connected to a cathode of the diode D1. An anode of the diode D1 is connected to a first end of the capacitor C1. A second end of the capacitor C1 is separately connected to a first input end of the drive module 133, the output end of the comparison unit 131, and the input end of the control unit 1321.

When a short circuit occurs in the circuit, the sampling voltage Vcs received by the first input end of the comparison unit 131 reaches the first reference voltage Vref1, and the output end of the comparison unit 131 outputs the overcurrent signal OCP. The drive module 133 turns off the switch component 110 in response to the overcurrent signal OCP that is used as the turn-off signal M. Although a voltage at a node between the sampling unit 120 and the switch component 110 is 0 after the switch component 110 is turned off, a voltage output by the output end of the comparison unit 131 in a period of time (that is, the first duration), that is, the overcurrent signal OCP, can increase the voltage at the first input end of the comparison unit 131 through a loop in which the capacitor C1, the diode D1, and the resistor R1 are located, to maintain output of the overcurrent signal OCP at the output end of the comparison unit 131, so as to continuously turn off the switch component 110 in a period of time. Because the overcurrent signal OCP continuously charges the capacitor C1 in the first duration, the voltage at the first input end of the comparison unit 131 gradually decreases. Therefore, when the first duration ends, the voltage at the first input end of the comparison unit 131 cannot reach the first reference voltage Vref1. In this way, the comparison unit 131 cannot output the overcurrent signal OCP. In other words, when the first duration ends, no turn-off signal M is output to the drive module 133. In this case, the drive module 133 can turn on the switch component 110 in response to the turn-on signal.

The control unit 1321 is configured to: receive the overcurrent signal OCP; and in response to that the quantity of times of the overcurrent signal OCP in the preset duration reaches the preset quantity of times, output the turn-off signal M for the second duration. The drive module 133 is configured to turn off the switch component 100 in response to the turn-off signal M. When the second duration ends, the drive module 133 can turn on the switch component 110 in response to the turn-on signal N.

Specifically, the input end of the control unit 1321 is separately connected to the second end of the capacitor C1, the output end of the comparison unit 131, and a second input end of the drive module 133. The output end of the control unit 1321 is connected to the second input end of the drive module 133.

It may be understood that a source of the turn-on signal is not limited in embodiments of this application. In a possible implementation, the control unit 1321 is further configured to output the turn-on signal N. One input end of the drive module 133 is configured to receive the turn-on signal N. The drive module 133 turns on the switch component 110 in response to the turn-on signal N.

It may be understood that the circuit shown in FIG. 3 is merely a circuit schematic. In actual application, another circuit implementation may be used.

In some embodiments, both the first-level control policy and the second-level control policy of the control module 132 are implemented by using the discrete component.

FIG. 4 is another schematic of the control circuit 130 in FIG. 2 according to an embodiment of this application.

A structure of a control circuit 130a is basically the same as that of the control circuit 130 in FIG. 3. A difference lies merely in that a structure of a control module 132a in the control circuit 130a is different from a structure of the control module 132 in the control circuit 130.

The control circuit 130a includes a comparison unit 131, the control module 132a, and a drive module 133. The control module 132a includes a resistor R1, a diode D1, a capacitor C1, a diode D2, a resistor R2, a capacitor C2, a resistor Rdis, a resistor R0, a comparator 1322, and a hysteresis control unit 1323. The hysteresis control unit 1323 includes a resistor Rs and a diode D3.

One end of the resistor R1 is connected to a first input end of the comparison unit 131 to receive a sampling voltage Vcs. The other end of the resistor R1 is connected to a cathode of the diode D1. An anode of the diode D1 is connected to a first end of the capacitor C1. A second end of the capacitor C1 is separately connected to an output end of the comparison unit 131, a first input end of the drive module 133, and an anode of the diode D2. A cathode of the diode D2 is connected to a first end of the resistor R2. A second end of the resistor R2 is separately connected to a first end of the capacitor C2 and a first end of the resistor R0. A second end of the capacitor C2 is connected to the ground. The resistor Rdis is connected in parallel to both ends of the capacitor C2. A second end of the resistor R0 is separately connected to a first input end of the comparator 1322 and a first end of the resistor Rs. A second end of the resistor Rs is connected to an anode of the diode D3, and a cathode of the diode D3 is connected to an output end of the comparator 1322. A second input end of the comparator 1322 is configured to receive a second reference voltage Vref2.

It may be understood that the comparison unit 131 outputs an overcurrent signal OCP, and the drive module 133 turns off a switch component 110 in response to the overcurrent signal OCP that is used as a turn-off signal M. When first duration ends, the drive module 133 can turn on the switch component 110 in response to a turn-on signal N. A specific principle has been described in the embodiment shown in FIG. 3. Details are not described herein again.

It may be understood that, in this embodiment, the turn-on signal N may be generated by another structure that is of the control module 132a and that is not shown. This is not limited in embodiments of this application. For example, the control module 132a may further include a sub-control unit, and the sub-control unit is configured to: in response to that the first duration or second duration ends, output the turn-on signal N.

In this embodiment, the overcurrent signal OCP charges the capacitor C2 after passing through the diode D2 and the resistor R2. When output of the comparator 1322 is at a low level, because a resistance value of the resistor R2 is smaller than resistance values of the resistor R0 and the resistor Rs, and the resistance values of the resistor R2, the resistor R0, and the resistor Rs are far smaller than a resistance value of the resistor Rdis, the capacitor C2 mainly discharges through the resistor R0 and the resistor Rs, and when the output of the comparator 1322 is at a high level, the capacitor C2 discharges through the resistor Rdis. When the comparison unit 131 does not output sufficient overcurrent signals OCP, the output of the comparator 1322 is at the low level, and a voltage at the first input end of the comparator 1322 is equal to a divided voltage formed by the capacitor C2 in a loop in which the resistor R0, the resistor Rs, and the diode D3 are located. After overcurrent occurs for a plurality of times, a voltage of the capacitor C2 gradually rises, and the voltage at the first input end of the comparator 1322 gradually rises. When the voltage at the first input end of the comparator 1322 reaches the second reference voltage Vref2, the output end of the comparator 1322 is set to the high level (that is, the output is at the high level), and the comparator 1322 outputs the turn-off signal M. In this case, the diode D3 is cut off, and the capacitor C2 cannot discharge through the loop in which the resistor R0, the resistor RS, and the diode D3 are located. The voltage at the first input end of the comparator 1322 is equal to the voltage of the capacitor C2, and the voltage is higher than the second reference voltage Vref2. The comparator 1322 is continuously set to the high level in a period of time (the second duration). During this period, the capacitor C2 gradually discharges through the resistor Rdis. After the second duration, the voltage at the first input end of the comparator 1322 cannot reach the second reference voltage Vref2. In this way, the comparator 1322 cannot output the turn-off signal M. In other words, when the second duration ends, no turn-off signal M is output to the drive module 133. In this case, the drive module 133 can turn on the switch component 110 in response to the turn-on signal N.

It may be understood that the circuit shown in FIG. 4 is merely a circuit schematic. In actual application, another circuit implementation may be used.

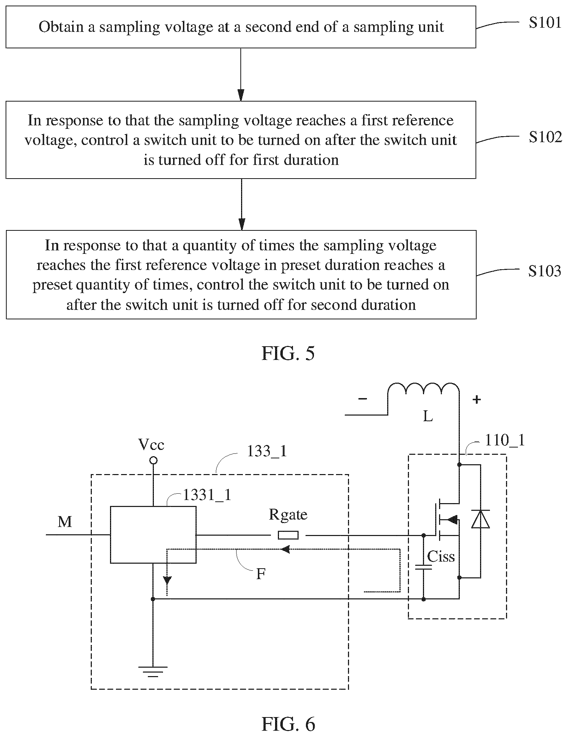

Refer to FIG. 5. An embodiment of this application further provides a switching circuit control method, which is applicable to the switching circuit 100 in the foregoing embodiment. As shown in FIG. 5, a voltage conversion apparatus control method includes the following steps.

Step S101: Obtain a sampling voltage at a second end of a sampling unit.

It may be understood that this step is performed by the control circuit 130. For example, as shown in FIG. 2, the first input end of the comparison unit 131 in the control circuit 130 is connected to the node between the sampling unit 120 and the switch component 110, to obtain the sampling voltage Vcs. For a specific working principle thereof, refer to FIG. 2 to FIG. 4 and related descriptions thereof. Details are not described herein again.

Step S102: In response to that the sampling voltage reaches a first reference voltage, control a switch component to be turned on after the switch component is turned off for first duration.

It may be understood that this step is performed by the control circuit 130. When the sampling voltage Vcs reaches the first reference voltage Vref1, the control circuit 130 controls the switch component 110 to be turned on after the switch component is turned off for the first duration. For a specific working principle thereof, refer to FIG. 2 to FIG. 4 and related descriptions thereof. Details are not described herein again.

Step S103: In response to that a quantity of times the sampling voltage reaches the first reference voltage in preset duration reaches a preset quantity of times, control the switch component to be turned on after the switch component is turned off for second duration. The second duration is greater than the first duration.

It may be understood that this step is performed by the control circuit 130. When a quantity of times the sampling voltage Vcs reaches the first reference voltage Vref1 in the preset duration reaches the preset quantity of times, the control circuit 130 controls the switch component 110 to be turned on after the switch component is turned off for the second duration. For a specific working principle thereof, refer to FIG. 2 to FIG. 4 and related descriptions thereof. Details are not described herein again.

An embodiment of this application further provides a drive module. The drive module is configured to drive a switch component. The drive module is applicable to the switching circuit 100 in the foregoing embodiment and is, for example, the drive module 133 in the control circuit 130.

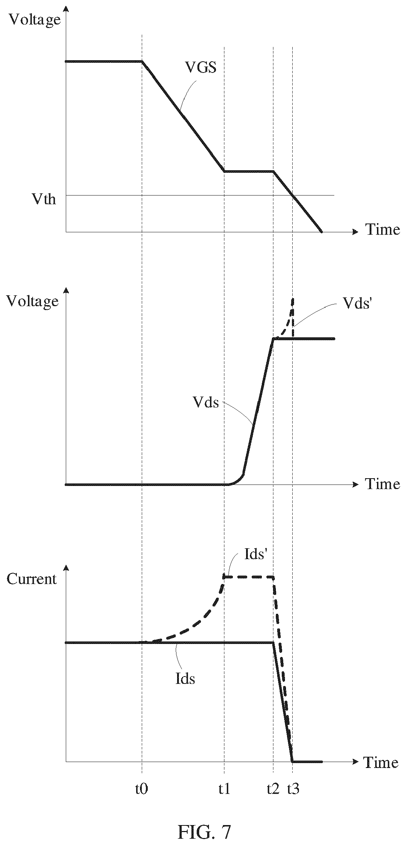

For better understanding of functions of the drive module provided in this application, refer to FIG. 6 and FIG. 7. FIG. 6 is a schematic of a connection between a drive module and a switch component. FIG. 7 is a waveform diagram of a voltage and a current in a turn-off process of the switch component in FIG. 6. For ease of description in the following, an example in which the switch component is a MOS transistor is used for description.

As shown in FIG. 6, a drive module 133_1 includes a turn-off unit 1331_1 and a drive resistor Rgate. The drive module 133_1 is connected to a control end of a MOS transistor 110_1 to control turn-on and turn-off of the MOS. Specifically, a first end of the drive resistor Rgate in the drive module 133_1 is connected to a gate of the MOS transistor 110_1. A first end of the turn-off unit 1331_1 is configured to receive a turn-off signal M, and a second end of the turn-off unit 1331_1 is configured to receive a power supply voltage Vcc. A first output end of the turn-off unit is connected to a second end of the drive resistor Rgate. The first output end of the turn-off unit is connected to the ground. A capacitor Ciss is an inter-electrode capacitor between the gate and a source of the MOS transistor. A first end of the capacitor Ciss is connected to the first end of the drive resistor Rgate. The first end of the capacitor Ciss is connected to the ground.

It may be understood that, after the drive module 133_1 receives the turn-off signal M, the drive resistor Rgate connected to the gate of the MOS transistor needs to be quickly connected to a low potential point, to form a discharging loop F to discharge the capacitor Ciss, and achieve an objective of turning off the MOS transistor. Therefore, a turn-off speed of the MOS transistor can be controlled through adjustment of a value of the drive resistor Rgate.

As shown in FIG. 7, a curve Vgs is a gate-source voltage curve of the MOS transistor, a curve Vds is a drain-source voltage (hereinafter briefly referred to as "drain-source voltage") curve of the MOS transistor, and a curve Ids is a drain-source current (hereinafter briefly referred to as "drain-source current") curve of the MOS transistor. A horizontal axis of a coordinate is time (time). A gate-source voltage Vgs starts to decrease at a moment t0. From a moment t1 to a moment t2, due to a characteristic of the MOS transistor 110_1, the gate-source voltage Vgs remains at a fixed voltage value, that is, enters a Miller plateau. After the moment t2, the gate-source voltage Vgs continues to decrease, and reaches a turn-off threshold voltage Vth of the MOS transistor 110_1 at a moment t3.

It can be learned from a transfer characteristic and an output characteristic of the MOS transistor 110_1 that the MOS transistor 110_1 is located in a variable resistance region in a time period from t0 to t1, and is located in a saturation region in a time period from t1 to t3. A drain-source current Ids=Vgs*Gm, and Gm represents transconductance. After the moment t3, the MOS transistor 110_1 enters a cut-off region.

In a time period from t1 to t2, because a gate discharge current is reversely charged via a Miller capacitor, a drain-source voltage Vds quickly rises from 0 to a platform voltage. After entry into the moment t2, the Miller plateau ends, and the gate-source voltage Vgs further decreases. It can be learned from the formula Ids=Vgs*Gm that the drain-source current Ids also starts to decrease.

It may be understood that a lead inductor L exists on a line connected to the MOS transistor 110_1. If a resistance value of the drive resistor Rgate is reduced to quickly turn off the MOS transistor 110_1, the gate-source voltage Vgs decreases excessively fast from the moment t2 to the moment t3, which causes the drain-source current Ids to decrease excessively fast. In this way, an excessively high voltage peak is formed on the lead inductor L, and a higher deceasing speed of the drain-source current Ids indicates a higher formed voltage peak. As shown by Vds' in FIG. 7, voltage overstress of the MOS transistor 110_1 is consequently prone to occur.

It may be understood that, increasing the resistance value of the drive resistor Rgate can reduce a decreasing speed of the gate-source voltage Vgs, thereby reducing voltage stress. However, after the decreasing speed of the gate-source voltage Vgs is reduced, the drain-source current Ids rises sharply from the moment t0 to the moment t1, as shown by a curve Ids' in FIG. 7. Consequently, current overstress of the MOS transistor 110_1 is prone to occur.

Clearly, reducing the resistance value of the drive resistor Rgate causes the voltage overstress, and increasing the resistance value of the drive resistor Rgate causes the current overstress. Therefore, problems of the voltage overstress and the current overstress of the MOS transistor 110_1 cannot be well resolved merely through adjustment of the resistance value of the drive resistor Rgate.

The drive module provided in this embodiment of this application is configured to drive the switch component. The drive module includes a first turn-off loop and a second turn-off loop. In response to a turn-off signal, a gate-source voltage of the switch component decreases. In response to that the gate-source voltage of the switch component is greater than a preset value, a current flowing through the first turn-off loop is greater than a current flowing through the second turn-off loop. In response to that the gate-source voltage of the switch component decreases to be less than or equal to a preset value, a current flowing through the first turn-off loop is less than or equal to a current flowing through the second turn-off loop. The preset value is greater than a turn-off threshold voltage of the switch component.

The drive module provided in this embodiment of this application can implement two levels of control manners of a turn-off speed through the two turn-off loops, namely, the first turn-off loop and the second turn-off loop, to resolve a problem that voltage overstress and current overstress cannot be resolved when the switch component is controlled to be turned off in a scenario in which a current of a line changes sharply, for example, in a short circuit or lightning strike working condition. In this way, requirements for voltage and current specifications of the switch component are greatly reduced.

For ease of description, the following uses an example in which the drive module is the drive module 133 in the foregoing embodiment and the switch component is the switch component 110 in the foregoing embodiment for description.

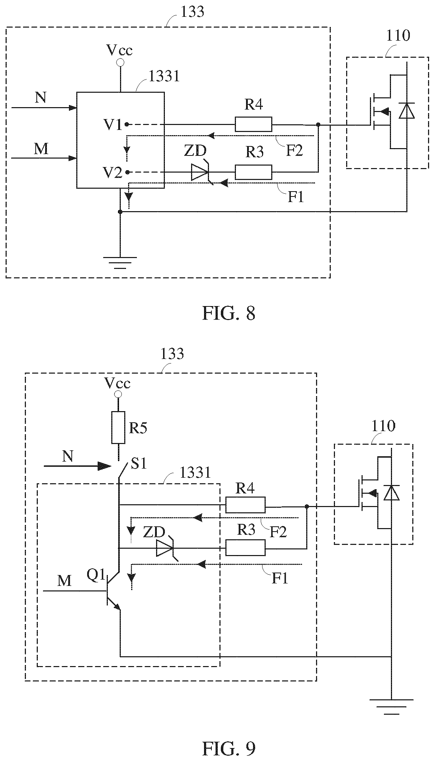

For example, FIG. 8 is a schematic of connection between a drive module and the switch component 110 according to an embodiment of this application. The drive module 133 includes a turn-off unit 1331, a first turn-off loop F1, and a second turn-off loop F2. A first end of the first turn-off loop F1 and a first end of the second turn-off loop F2 are respectively connected to a control end of the switch component 110, and a second end V1 of the first turn-off loop F1 and a second end V2 of the second turn-off loop F2 are respectively connected to the turn-off unit 1331.

A power supply end of the turn-off unit 1331 is configured to receive a power supply voltage Vcc. The power supply voltage Vcc is configured to supply power to a drive unit 110. A source of the power supply voltage Vcc is not limited in embodiments of this application. The power supply voltage Vcc is, for example, 12 V. A first end of the turn-off unit 1331 is connected to the second end V1 of the first turn-off loop F1 and the second end V2 of the second turn-off loop F2. A second end of the turn-off unit 1331 is further connected to a source of the switch component 110. A third end of the turn-off unit 1331 is connected to an output end of a control module 132 to receive a turn-off signal M. A fourth end of the turn-off unit 1331 is connected to the output end of the control module 132, to receive a turn-on signal N. It may be understood that V1 and V2 in FIG. 8 are merely examples. In an actual circuit, V1 and V2 may be equipotential points. Inside the turn-off unit 1331, the second end V1 of the first turn-off loop F1 and the second end V2 of the second turn-off loop F2 can be connected, with a low impedance, to the fourth end of the turn-off unit 1331, to be connected to the source of the switch component 110 to form a discharging loop.

In this embodiment, in response to the turn-off signal M, a gate-source voltage of the switch component 110 decreases. In response to that the gate-source voltage of the switch component 110 is greater than a preset value, a current flowing through the first turn-off loop F1 is greater than a current flowing through the second turn-off loop F2. In response to that the gate-source voltage of the switch component 110 decreases to be less than or equal to a preset value, a current flowing through the first turn-off loop F1 is less than or equal to a current flowing through the second turn-off loop F2. The preset value is greater than a turn-off threshold voltage of the switch component 110. In a possible implementation, the preset value is close to a voltage at which a Miller plateau of the switch component 110 is. In a possible embodiment, the first turn-off loop F1 includes a resistor R3 and a Zener diode ZD. The second turn-off loop F2 includes a resistor R4. A resistance value of the resistor R3 is less than a resistance value of the resistor R4. A first end of the resistor R3 and a first end of the resistor R4 are respectively connected to the control end of the switch component 110. A second end of the resistor R3 is connected to a cathode of the Zener diode ZD. An anode of the Zener diode ZD is connected to the first end of the turn-off unit 1331. A second end of the resistor R4 is connected to the first end of the turn-off unit 1331.

In response to that the turn-off unit 1331 (for example, the third end of the turn-off unit 1331) receives the turn-off signal M, the first end of the turn-off unit 1331 is connected, with a low impedance, to the second end of the turn-off unit 1331, so that the gate-source voltage of the switch component 110 decreases. It may be understood that, when the first end and the second end of the turn-off unit 1331 are connected, both the first turn-off loop F1 and the second turn-off loop F2 are connected to the source of the switch component 110, to form the discharging loop, so that the gate-source voltage of the switch component 110 decreases. In response to that the gate-source voltage of the switch component 110 is less than a reverse breakdown voltage of the Zener diode ZD, no current passes through the first turn-off loop F1. It may be understood that a specific structure of the turn-off unit 1331 is not limited in embodiments of this application. The turn-off unit 1331 may be, for example, a transistor or a MOS transistor.

For example, refer to FIG. 9. In a possible implementation, the drive module 133 includes a resistor R5, a switch S1, the turn-off unit 1331, the resistor R3, and the resistor R4. The turn-off unit 1331 includes a transistor Q1 and a voltage regulator tube ZD. The resistance value of the resistor R3 is less than the resistance value of the resistor R4. A regulated voltage value of the voltage regulator tube ZD is greater than the turn-off threshold voltage of the switch component 110.

The first end of the resistor R3 and the first end of the resistor R4 are respectively connected to the control end of the switch component 110. A first end of the resistor R5 is configured to receive the power supply voltage Vcc. A second end of the resistor R5 is connected to a first end of the switch S 1. A first end (a base) of the transistor Q1 is connected to an output end of a comparison unit 131 to receive the turn-off signal M. A second end (a collector) of the transistor Q1 is separately connected to a second end of the switch S 1, the second end of the resistor R4, and a positive end of the voltage regulator tube ZD. A negative end of the voltage regulator tube ZD is connected to the second end of the resistor R3. The switch S1 is configured to receive the turn-on signal N.

In this embodiment, in response to outputting the turn-off signal M, the control module 132 controls the switch S1 in the drive module 133 to be turned on. For example, when the control module 132 outputs the turn-off signal M, the control module 132 sets the turn-on signal N to a low level to control the switch S1 to be turned on. When the first end of the transistor Q1 receives the turn-off signal M, the transistor Q1 is conducted to form two discharging loops, that is, a first discharging loop F1 in which the voltage regulator tube ZD and the resistor R3 are located, and a second discharging loop F2 in which the resistor R4 is located. The first discharging loop F1 and the second discharging loop F2 are configured to reduce the gate-source voltage of the switch component 110. Because the resistance value of the resistor R3 is small, a discharging speed of the first discharging loop F1 is high. The switch component 110 can implement first-level quick turn-off. After the gate-source voltage of the switch component 110 decreases to be less than the reverse breakdown voltage of the Zener diode ZD, no current passes through the first turn-off loop F1. The gate-source voltage of the switch component 110 decreases again through the second discharging loop F2, to implement second-level slow turn-off of a drive voltage. It may be understood that, in this embodiment, when the control module 132 does not output the turn-off signal M, the control module 132 is configured to set the turn-on signal N to a high level to control the switch S1 to be turned off. In this way, the switch component 110 can be turned on by using the drive module 133.

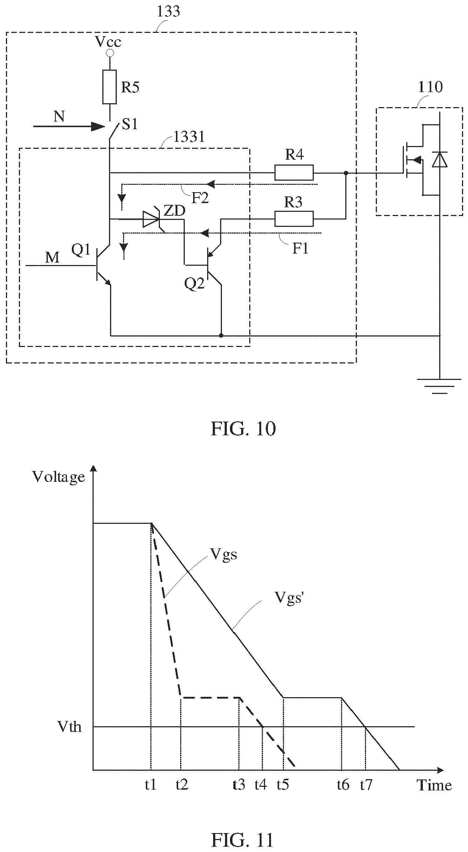

For another example, also refer to FIG. 10. In another possible implementation, a transistor Q2 is further disposed in the drive module 133. The transistor Q3 is configured to amplify a current output by the negative end of the voltage regulator tube ZD, so that the switch component 110 can be more quickly turned off through a loop in which the voltage regulator tube ZD and the resistor R3 are located.

It may be understood that a difference between FIG. 10 and FIG. 9 lies merely in that the transistor Q2 is disposed between the voltage regulator tube ZD and the resistor R3. For example, the transistor Q2 is a PNP transistor. A first end (a base) of the transistor Q2 is connected to the negative end of the voltage regulator tube ZD. A second end (an emitter) of the transistor Q2 is connected to the second end of the resistor R3. A third end (a collector) of the transistor Q2 is connected to the ground.

It may be understood that connection relationships between other elements are consistent with those in FIG. 9. Details are not described herein again.

Also refer to FIG. 11. FIG. 11 is a schematic of a drive voltage curve in a turn-off process of a switch component according to an embodiment of this application. For example, a switch component used by the switch component 110 is a MOS transistor.

As shown in FIG. 11, a curve Vgs' is a gate-source voltage curve obtained when the MOS transistor in the switch component is normally turned on, that is, a drive voltage curve of the MOS transistor. A curve Vgs is a gate-source voltage curve obtained when the MOS transistor in the switch component is turned on according to this embodiment of this application.

Before a moment t1, the curve Vgs overlaps the curve Vgs'.

At the moment t1, a turn-off circuit 1331 receives a turn-off signal M, and the MOS transistor can implement first-level quick turn-off through a first turn-off loop F1 in which a resistor R3 is located. Therefore, a slope of the curve Vgs from the moment t1 to a moment t2 is clearly greater than a slope of the curve Vgs' from the moment t1 to a moment t5. In other words, a resistance value of the resistor R3 is reduced, so that duration of a time period from t1 to t2 can be reduced. It can be learned from a circuit principle that, if the resistance of R3 is large, a drain-source current Ids of the MOS transistor rises rapidly from the moment t1 to the moment t2 (refer to FIG. 7). Therefore, the resistance value of the resistor R3 is reduced, to increase the duration of the time period from t1 to t2, so that rapid rise of the drain-source current Ids of the MOS transistor can be effectively suppressed. In this way, a problem of current overstress of the MOS transistor can be resolved.

From the moment t2 to a moment t3 for the curve Vgs, and from a moment t5 to a moment t6 for the curve Vgs', due to a characteristic of the MOS transistor in the switch component 110, a gate-source voltage Vgs remains at a fixed voltage value, that is, enters a Miller plateau.

After the moment t3, the gate-source voltage Vgs continues to decrease. After the gate-source voltage Vgs decreases to be close to a regulated voltage of the voltage regulator tube ZD, the gate-source voltage Vgs can implement second-level slow turn-off merely through a second discharging loop F2 in which a resistor R4 with a large resistance value is located. In this way, rapid decrease of the gate-source voltage Vgs can be avoided, to avoid a problem of voltage overstress of the MOS transistor.

At a moment t4, the gate-source voltage Vgs reaches a turn-off threshold voltage Vth, and the switch component 110 is turned off. A normal turn-off moment of the MOS transistor, that is, a time point existing when quick turn-off in this embodiment of this application is not adopted, is a moment t7. Clearly, the moment t4 is earlier than the moment t7. In other words, in this embodiment of this application, a turn-off speed of the switch component 110 can be faster.

It may be understood that, the resistor R3 in a drive module 133 in this embodiment of this application is connected in series to the voltage regulator tube ZD, and then is connected in parallel to the resistor R4. When the drive module 133 receives the turn-off signal, the first turn-off loop F1 in which the resistor R3 is located implements first-level quick turn-off. A second turn-off loop F4 in which the resistor R4 is located implements second-level slow turn-off. The two levels of turn-off control are set, and this can resolve a problem that the voltage overstress and the current overstress cannot be resolved when the switch component is controlled to be turned off in a scenario in which a current of a line changes sharply, for example, in a short circuit or lightning strike working condition. In this way, requirements for voltage and current specifications of the switch component are greatly reduced.

A person of ordinary skill in the art should understand that the foregoing implementations are merely intended to describe this application but are not intended to limit this application, provided that proper modifications and changes made to the foregoing embodiments in the substantive scope of this application fall within the protection scope of this application.

## Claims

1. A switching circuit, configured to conduct or cut off power supplied by a power supply apparatus to a load, wherein the switching circuit comprises:
a sampling unit, wherein a first end of the sampling unit is configured to connect to an output end of the power supply apparatus;
a switch component, wherein one end of the switch component is configured to connect to a second end of the sampling unit, and the other end of the switch component is configured to connect to the load; and
a control circuit, wherein the control circuit is connected to the second end of the sampling unit and a control end of the switch component, and the control circuit is configured to: in response to that a sampling voltage at the second end of the sampling unit reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration, wherein the second duration is greater than the first duration.

2. The switching circuit according to claim 1, wherein the control circuit comprises:
a comparison unit, configured to: receive the first reference voltage and the sampling voltage; and in response to that the sampling voltage reaches the first reference voltage, output an overcurrent signal;
a control module, configured to: in response to the overcurrent signal, output the turn-off signal for the first duration; in response to that a quantity of times of the overcurrent signal in the preset duration reaches the preset quantity of times, output the turn-off signal for the second duration; and in response to that the first duration or the second duration ends, output a turn-on signal, wherein the second duration is greater than the first duration; and
a drive module, configured to: in response to the turn-off signal, turn off the switch component; and in response to the turn-on signal, turn on the switch component.

3. The switching circuit according to claim 2, wherein the drive module comprises a first turn-off loop and a second turn-off loop, and in response to the turn-off signal, a gate-source voltage of the switch component decreases; and
in response to that the gate-source voltage of the switch component is greater than a preset value, a current flowing through the first turn-off loop is greater than a current flowing through the second turn-off loop; or
in response to that the gate-source voltage of the switch component decreases to be less than or equal to a preset value, a current flowing through the first turn-off loop is less than or equal to a current flowing through the second turn-off loop, wherein
the preset value is greater than a turn-off threshold voltage of the switch component.

4. The switching circuit according to claim 3, wherein the drive module comprises a turn-off unit, the first turn-off loop comprises a first resistor and a Zener diode, the second turn-off loop comprises a second resistor, a resistance value of the first resistor is less than a resistance value of the second resistor, a first end of the first turn-off loop and a first end of the second turn-off loop are separately connected to the control end of the switch component, a second end of the first turn-off loop and a second end of the second turn-off loop are separately connected to a first end of the turn-off unit, and a second end of the turn-off unit is connected to a source of the switch component;
in response to that a third end of the turn-off unit receives the turn-off signal, the first end of the turn-off unit is connected, with a low impedance, to the second end of the turn-off unit, so that the gate-source voltage of the switch component decreases; and
in response to that the gate-source voltage of the switch component is less than a reverse breakdown voltage of the Zener diode, no current passes through the first turn-off loop.

5. The switching circuit according to any one of claims 2 to 4, wherein the control module comprises a discrete element and/or an integrated element.

6. The switching circuit according to any one of claims 1 to 5, wherein the comparison unit and the control module are integrated into a same chip.

7. A drive module, configured to drive a switch component, wherein the drive module comprises a first turn-off loop and a second turn-off loop, and in response to a turn-off signal, a gate-source voltage of the switch component decreases; and
in response to that the gate-source voltage of the switch component is greater than a preset value, a current flowing through the first turn-off loop is greater than a current flowing through the second turn-off loop; or
in response to that the gate-source voltage of the switch component decreases to be less than or equal to a preset value, a current flowing through the first turn-off loop is less than or equal to a current flowing through the second turn-off loop, wherein
the preset value is greater than a turn-off threshold voltage of the switch component.

8. The drive module according to claim 7, wherein the drive module comprises a turn-off unit, the first turn-off loop comprises a first resistor and a Zener diode, the second turn-off loop comprises a second resistor, a resistance value of the first resistor is less than a resistance value of the second resistor, a first end of the first turn-off loop and a first end of the second turn-off loop are separately connected to a control end of the switch component, a second end of the first turn-off loop and a second end of the second turn-off loop are separately connected to a first end of the turn-off unit, and a second end of the turn-off unit is connected to a source of the switch component;
in response to that a third end of the turn-off unit receives the turn-off signal, the first end of the turn-off unit is connected, with a low impedance, to the second end of the turn-off unit, so that the gate-source voltage of the switch component decreases; and
in response to that the gate-source voltage of the switch component is less than a reverse breakdown voltage of the Zener diode, no current passes through the first turn-off loop.

9. A switching circuit, configured to conduct or cut off power supplied by a power supply apparatus to a load, wherein the switching circuit comprises:
a sampling unit, wherein a first end of the sampling unit is configured to connect to an output end of the power supply apparatus;
a switch component, wherein one end of the switch component is configured to connect to a second end of the sampling unit, and the other end of the switch component is configured to connect to the load; and
a control circuit, wherein the control circuit comprises a control module and a drive module, the control module is configured to: in response to that a sampling voltage at the second end of the sampling unit meets a preset condition, output a turn-off signal, and the drive module is configured to: in response to the turn-off signal, turn off the switch component, wherein
the drive module comprises a first turn-off loop and a second turn-off loop, and in response to the turn-off signal, a gate-source voltage of the switch component decreases; and in response to that the gate-source voltage of the switch component is greater than a preset value, a current flowing through the first turn-off loop is greater than a current flowing through the second turn-off loop; or in response to that the gate-source voltage of the switch component decreases to be less than or equal to a preset value, a current flowing through the first turn-off loop is less than or equal to a current flowing through the second turn-off loop, wherein the preset value is greater than a turn-off threshold voltage of the switch component.

10. The switching circuit according to claim 9, wherein the drive module comprises a turn-off unit, the first turn-off loop comprises a first resistor and a Zener diode, the second turn-off loop comprises a second resistor, a resistance value of the first resistor is less than a resistance value of the second resistor, a first end of the first turn-off loop and a first end of the second turn-off loop are separately connected to a control end of the switch component, a second end of the first turn-off loop and a second end of the second turn-off loop are separately connected to a first end of the turn-off unit, and a second end of the turn-off unit is connected to a source of the switch component;
in response to that a third end of the turn-off unit receives the turn-off signal, the first end of the turn-off unit is connected, with a low impedance, to the second end of the turn-off unit, so that the gate-source voltage of the switch component decreases; and
in response to that the gate-source voltage of the switch component is less than a reverse breakdown voltage of the Zener diode, no current passes through the first turn-off loop.

11. The switching circuit according to claim 10, wherein the preset condition is that the sampling voltage reaches a first reference voltage, or a quantity of times the sampling voltage reaches the first reference voltage within preset duration reaches a preset quantity of times; and
the control circuit is configured to: in response to that the sampling voltage reaches the first reference voltage, control the switch component to be turned on after the switch component is turned off for first duration; and in response to that the quantity of times the sampling voltage reaches the first reference voltage in the preset duration reaches the preset quantity of times, control the switch component to be turned on after the switch component is turned off for second duration, wherein the second duration is greater than the first duration.

12. The switching circuit according to claim 11, wherein the control circuit comprises:
a comparison unit, configured to: receive the first reference voltage and the sampling voltage; and in response to that the sampling voltage reaches the first reference voltage, output an overcurrent signal, wherein
the control module is configured to: in response to the overcurrent signal, output the turn-off signal for the first duration; in response to that a quantity of times of the overcurrent signal in the preset duration reaches the preset quantity of times, output the turn-off signal for the second duration; and in response to that the first duration or the second duration ends, output a turn-on signal, wherein the second duration is greater than the first duration; and
the drive module is configured to: in response to the turn-off signal, turn off the switch component; and in response to the turn-on signal, turn on the switch component.

13. A switching circuit control method, wherein the switching circuit comprises a sampling unit and a switch component, a first end of the sampling unit is configured to connect to an output end of the power supply apparatus, one end of the switch component is configured to connect to a second end of the sampling unit, the other end of the switch component is configured to connect to the load, and the method comprises:
obtaining a sampling voltage at the second end of the sampling unit;
in response to that the sampling voltage reaches a first reference voltage, controlling the switch component to be turned on after the switch component is turned off for first duration; and
in response to that a quantity of times the sampling voltage reaches the first reference voltage in preset duration reaches a preset quantity of times, controlling the switch component to be turned on after the switch component is turned off for second duration, wherein
the second duration is greater than the first duration.

14. A power supply device, comprising:
a power supply apparatus, configured to provide a direct current output voltage for a load; and
a switching circuit, configured to conduct or cut off power supplied by the power supply apparatus to the load, wherein
the switching circuit comprises a sampling unit, a switch component, and a control circuit, a first end of the sampling unit is configured to connect to an output end of the power supply apparatus, one end of the switch component is configured to connect to a second end of the sampling unit, the other end of the switch component is configured to connect to the load, the control circuit is connected to the second end of the sampling unit and a control end of the switch component, and the control circuit is configured to: in response to that a sampling voltage at the second end of the sampling voltage reaches a first reference voltage, control the switch component to be turned on after the switch component is turned off for first duration; and in response to that a quantity of times the sampling voltage reaches the first reference voltage in preset duration reaches a preset quantity of times, control the switch component to be turned on after the switch component is turned off for second duration, wherein the second duration is greater than the first duration.

15. A power supply device, comprising:
a power supply apparatus, configured to provide a direct current output voltage for a load; and
a switching circuit, configured to conduct or cut off power supplied by the power supply apparatus to the load, wherein
the switching circuit comprises a sampling unit, a switch component, and a control circuit, the control circuit comprises a control module and a drive module, the control module is configured to: in response to that a sampling voltage at a second end of the sampling unit meets a preset condition, output a turn-off signal, and the drive module is configured to: in response to the turn-off signal, turn off the switch component, wherein the drive module comprises a first turn-off loop and a second turn-off loop, and in response to the turn-off signal, a gate-source voltage of the switch component decreases; and in response to that the gate-source voltage of the switch component is greater than a preset value, a current flowing through the first turn-off loop is greater than a current flowing through the second turn-off loop; or in response to that the gate-source voltage of the switch component decreases to be less than or equal to a preset value, a current flowing through the first turn-off loop is less than or equal to a current flowing through the second turn-off loop, wherein the preset value is greater than a turn-off threshold voltage of the switch component.
